# EUROPEAN PATENT APPLICATION

(11) **EP 1 930 966 A2**
(43) Date of publication of application: **11.06.2008**
(21) Application number: 07114963.7
(22) Date of filing: 24.08.2007
(51) Int. Cl.: H01L 51/52

(54) **Barrier layer, composite article comprising the same, electroactive device, and method**

(30) Priority: 06.12.2006 US 567307
(71) Applicant: General Electric Company, Schenectady, NY 12345 (US)
(72) Inventor: Lewis, Larry Neil, Scotia, NY 12302 (US); Erlat, Ahmet Gun, Clifton Park, NY 12065 (US); Yan, Min, Ballston Lake, NY 12019 (US); Breitung, Eric Michael, New York, NY 10023 (US); Duggal, Anil Raj, Niskayuna, NY 12309 (US)
(74) Representative: Szary, Anne Catherine

(57) **Abstract**

A barrier layer (16), a composite article (10) comprising the barrier layer (16) and a substrate (14), and a method for making the composite article are provided. The barrier layer (16) is disposed on a surface of the substrate (14), wherein the barrier layer (16) comprises a barrier coating and a repair coating disposed on the barrier coating. The repair coating comprises a metal based compound. An electroactive device comprising the composite article (10) is also provided.

## Description

### BACKGROUND

The invention relates generally to barrier layers, composite articles comprising the barrier layers, and methods of making the same. The invention also relates to devices sensitive to chemical species and especially electroactive devices comprising the composite articles.

Electroactive devices such as electroluminescent (EL) devices are well-known in graphic display and imaging art. EL devices have been produced in different shapes for many applications and may be classified as either organic or inorganic. Organic electroluminescent devices, which have been developed more recently, offer the benefits of lower activation voltage and higher brightness, in addition to simple manufacture and thus the promise of more widespread applications compared to inorganic electroluminescent devices.

An organic electroluminescent device is typically a thin film structure formed on a substrate such as glass, transparent plastic or metal foil. A light emitting layer of an organic EL material and optional adjacent semiconductor layers are sandwiched between a cathode and an anode. Conventional organic electroluminescent devices are built on glass substrates because of a combination of transparency and low permeability to oxygen and water vapor. However, glass substrates are not suitable for certain applications in which flexibility is desired. Flexible plastic substrates have been used to build organic electroluminescent devices. However, the plastic substrates are not impervious to environmental factors such as oxygen, water vapor, hydrogen sulfide, SOₓ, NOₓ, solvents, and the like, resistance to which factors is often termed collectively as environmental resistance. Environmental factors, typically oxygen and water vapor permeation, may cause degradation over time and thus may decrease the lifetime of the organic electroluminescent devices in flexible applications. Previously, the issue of oxygen and water vapor permeation has been addressed by applying alternating layers of polymeric and ceramic materials over the substrate. The fabrication of such alternating layers of polymeric and ceramic materials requires multiple steps and hence is time consuming and uneconomical.

Therefore, there is a need to improve the environmental resistance of substrates in electroactive devices such as organic electroluminescent devices and to develop a method of doing the same, in a manner requiring a minimal number of processing steps.

### BRIEF DESCRIPTION

According to one embodiment of the invention there is provided a composite article comprising: a substrate having a surface; and a barrier layer disposed on a surface of the substrate; wherein the barrier layer comprises a barrier coating and a repair coating disposed on the barrier coating, wherein the repair coating comprises a metal based compound.

In another embodiment of the invention there is provided method of making a composite article comprising the steps of: (i) providing a flexible substrate having a surface; (ii) depositing a barrier coating on the surface of the substrate; and (iii) disposing a metal based compound on the barrier coating to form a repair coating.

In another embodiment of the invention there is provided a light emitting device comprising: a flexible, substantially transparent substrate having a surface; a barrier layer disposed on a surface of the substrate; and an organic electroluminescent structure comprising an organic electroluminescent layer disposed between two electrodes; wherein the barrier layer comprises a barrier coating and a repair coating disposed on the barrier coating, wherein the repair coating comprises a metal based compound.

In yet another embodiment of the invention there is provided a barrier layer disposed on a surface of a substrate; wherein the barrier layer comprises a barrier coating and a repair coating comprising a metal based compound disposed on the barrier coating, wherein the barrier coating is selected from the group consisting of oxides, nitrides, carbides, and borides of elements of Groups IIA, IIIA, IVA, VA, VIA, VIIA, IB, IIB, metals of Groups IIIB, IVB, VB, rare earth elements, and any combination thereof; wherein the repair coating comprises either (i) silica, titania, alumina or any combination thereof or (ii) metal oxide nanoparticles having an average size in the range of from about 0.5 nanometers (nm) to about 100 nm or (iii) a condensation product of a metal alkoxide, wherein the metal alkoxide comprises trimethoxy methylsilane, tetraethoxy orthosilane, trisilanol isooctyl polyhedral oligomeric silsesquioxane, trisilanol phenyl polyhedral oligomeric silsesquioxane, titanium isopropoxide or any combination thereof; and wherein the barrier layer has an oxygen transmission rate of less than about 0.1 cm³/m²/day, as measured at 25°C and with a gas containing 21 volume percent oxygen, and a water vapor transmission rate through the barrier layer of less than about 1x10⁻² g/m²/day, as measured at 25°C and with a gas having 50 percent relative humidity.

### BRIEF DESCRIPTION OF THE DRAWINGS

These and other features, aspects, and advantages of the present invention will become better understood when the following detailed description is read with reference to the accompanying drawings wherein:

Figure 1 shows a transmission electron microscopy (TEM) image of silica particles in a colloidal solution.

Figure 2 shows a TEM image of titanium dioxide particles in a colloidal solution.

Figure 3 shows a TEM image of titanium dioxide particles in a colloidal solution.

Figure 4 shows a composite article comprising a barrier layer and a substrate layer according to one embodiment of the present invention.

Figure 5 shows a composite article comprising a barrier layer and a substrate layer and further comprising an organic electroluminescent layer according to another embodiment of the invention.

Figure 6 shows a composite article comprising a barrier layer and a substrate layer and further comprising an organic electroluminescent layer in yet another embodiment of the invention.

Figure 7 shows a composite article comprising a barrier layer and a substrate layer and further comprising a light scattering layer according to yet another embodiment of the invention.

### DETAILED DESCRIPTION

In the following specification and the claims which follow, reference will be made to a number of terms which shall be defined to have the following meanings. The singular forms "a", "an" and "the" include plural referents unless the context clearly dictates otherwise. The phrases "environmental resistance" and "resistance to diffusion of chemical species" are used interchangeably.

According to one embodiment of the invention, a composite article is provided comprising a barrier layer disposed over a surface of a substrate. The barrier layer comprises a barrier coating in contact with the substrate and a repair coating disposed on the barrier coating. Composite articles having the repair coating on the barrier coating as described in embodiments of the invention have improved resistance to diffusion of chemical species and, hence, extended life, rendering them more commercially viable.

In some embodiments the substrate material may be flexible and/or substantially transparent. The substrate may be a single piece or a structure comprising a plurality of adjacent pieces of different materials. Illustrative substrate materials comprise organic polymeric resins; such as, but not limited to, a polyethylene terephthalate (PET), a polyacrylate, a polynorbornene, a polycarbonate, a silicone, an epoxy resin, a silicone-functionalized epoxy resin, a polyester such as MYLAR® (available from E. I. du Pont de Nemours & Co.), a polyimide such as KAPTON® H or KAPTON® E (available from du Pont), APICAL® AV (available from Kaneka High-Tech Materials), UPILEX® (available from Ube Industries, Ltd.), a polyethersulfone, a polyetherimide such as ULTEM® (available from General Electric Company), a poly(cyclic olefin), or a polyethylene naphthalate (PEN). Other illustrative substrate materials comprise a glass, a metal or a ceramic. Combinations of substrate materials are also within the scope of the invention.

In certain embodiments additional layers may be disposed on the substrate prior to application of the barrier coating. In one embodiment of the invention a planarizing layer is provided on the substrate. The planarizing layer composition comprises at least one resin. In a further aspect of the invention the resin is an epoxy based resin. For example, the resin could be a cycloaliphatic epoxy resin such as, but not limited to, 3,4-epoxycyclohexylmethyl-3,4-epoxycyclohexylcarboxylate. Illustrative examples of cycloaliphatic epoxy resins include, but are not limited to, Dow ERL4221, ERL4299, ERLX4360, CYRACURE® UVR-6100 series and cycloaliphatic diepoxy disiloxanes such as those available from Silar Labs. The epoxy based resins may impart increased surface durability, for example, by improving resistance to scratch and damage that may likely happen during fabrication or transportation. Moreover, the siloxane portion of certain diepoxies may be easily adjusted in length and branching to optimize desired properties. In another aspect of the present invention, the resin is an acrylic based resin.

The planarizing layer composition may further comprise at least one flexibilizing agent, adhesion promoter, surfactant, catalyst or combinations thereof. A flexibilizing agent helps make the planarizing layer less brittle and more flexible by reducing the cracking or peeling and generally reducing the stress the coating applies to the underlying substrate. Illustrative examples of flexibilizing agents include, but are not limited to, Dow D.E.R.® 732 and 736, cyclohexane dimethanol, Celanese TCD alcohol DM, and King Industries K-FLEX® 148 and 188. An adhesion promoter may help to improve adhesion between the substrate and the barrier coating. For example, an adhesion promoter such as an organic silane coupling agent binds to the surface of the substrate and the subsequent barrier coating applied over the substrate. It is believed that a surfactant helps lower the surface energy of the barrier coating, allowing it to wet a substrate, and level better, providing a smoother, more uniform coating. Illustrative examples of surfactants include, but are not limited to, OSI SILWET® L-7001 and L-7604, GE SF1188A, SF1288, and SF1488, BYK-Chemie BYK®-307, and Dow TRITON® X.

In still another aspect of the present invention the planarizing layer may be cured. Illustrative curing methods include radiation curing, thermal curing, or combinations thereof. In one specific example, the radiation curing comprises ultraviolet (UV) curing. Other illustrative curing methods include anhydride or amine curing. Illustrative examples of UV curing agents include, but are not limited to, Dow CYRACURE® UVI-6976 and UVI-6992, Ciba IRGACURE® 250, and GE UV9380C. Non-limiting examples of thermal curing catalysts comprise King Industries CXC-162, CXC-1614, and XC-B220, and 3M FC520

Other optional additives can be incorporated into the planarizing layer to tailor its properties. Illustrative additives may comprise a UV catalyst, a UV absorber such as Ciba TINUVIN®, a UV sensitizer such as isopropylthioxanthone or ethyl dimethoxyanthracene, an antioxidant such as Ciba Geigy's IRGANOX® hindered amine complexes, and leveling agents such as BYK-Chemie BYK®-361. Siloxane additives can be included to make the planarizing layer more scratch resistant.

Illustrative barrier coating compositions comprise those selected from organic materials, inorganic materials, ceramic materials, and any combination thereof. In one example, these materials are recombination products derived from reacting plasma species, and are deposited on the substrate surface. Organic barrier coating materials typically comprise carbon and hydrogen, and optionally other elements, such as oxygen, sulfur, nitrogen, silicon and like elements, depending on the types of reactants. Suitable reactants that result in organic compositions in the barrier coating comprise straight or branched alkanes, alkenes, alkynes, alcohols, aldehydes, ethers, alkylene oxides, aromatics, or like species, having up to about 15 carbon atoms. Inorganic and ceramic barrier coating materials typically comprise oxides, nitrides, borides, or any combinations thereof, of elements of Groups IIA, IIIA, IVA, VA, VIA, VIIA, IB or IIB; metals of Groups IIIB, IVB, or VB, or rare earth elements. For example, a barrier coating comprising silicon carbide can be deposited on a substrate by recombination of plasmas generated from silane and an organic material, such as methane or xylene. A barrier coating comprising silicon oxycarbide can be deposited from plasmas generated from silane, methane, and oxygen, or silane and propylene oxide, or from plasma generated from organosilicone precursors, such as tetraethoxy orthosilane (TEOS), hexamethyl disiloxane (HMDS), hexamethyl disilazane (HMDZ), or octamethyl cyclotetrasiloxane (D4). A barrier coating comprising silicon nitride can be deposited from plasmas generated from silane and ammonia. A barrier coating comprising aluminum oxycarbonitride can be deposited from a plasma generated for example from a mixture of aluminum tartrate and ammonia. Other combinations of reactants may be chosen to obtain a desired barrier coating composition. A graded composition of the barrier coating may be obtained by changing the compositions of the reactants fed into the reactor chamber during the deposition of reaction products to form the coating.

In other embodiments the barrier coating may comprise hybrid organic/inorganic materials or multilayer organic/inorganic materials. In still other embodiments the organic materials may comprise an acrylate, an epoxy, an epoxyamine, a siloxane, a silicone, or the like. In some embodiments barrier coatings comprising organic materials may be deposited using known methods such as, but not limited to, spin coating, flow coating, gravure or microgravure process, dip coating, spray coating, vacuum deposition, plasma enhanced chemical vapor deposition, or like methods. Metals may also be suitable for the barrier coating in applications where transparency is not required.

The thickness of the barrier coating is in one embodiment in the range from about 10 nm to about 10,000 nm, in another embodiment in the range from about 10 nm to about 1000 nm, and in still another embodiment in the range from about 10 nm to about 200 nm. It may be desirable to choose a barrier coating thickness that does not impede the transmission of light through the substrate. In one embodiment the reduction in light transmission is less than about 20 percent, in another embodiment less than about 10 percent, and in still another embodiment less than about 5 percent compared to a substantially transparent substrate. In some embodiments the barrier coating does not affect the flexibility of the substrate.

The barrier coating may be formed on a surface of the substrate by one of many known deposition techniques, such as, but not limited to, plasma enhanced chemical vapor deposition (PECVD), radio frequency plasma enhanced chemical vapor deposition (RF-PECVD), expanding thermal-plasma chemical vapor deposition, reactive sputtering, electron-cyclotron-resonance plasma enhanced chemical vapor deposition (ECRPECVD), inductively coupled plasma enhanced chemical vapor deposition (ICPECVD), sputter deposition, evaporation, atomic layer deposition, or combinations thereof. In some embodiments the barrier coating may encapsulate either the substrate, or the substrate and one or more other layers comprising a composite article, or an electroactive device as described in embodiments of the invention.

The barrier coating obtained as described above may contain defects such as voids. Such voids may comprise pores, pinholes, cracks, or the like. The barrier coating may have a single defect or multiple defects. The defects may allow permeation of oxygen, water vapor, or other chemical species through an area of the defect. The infiltration of oxygen and water vapor through the barrier coating may damage a surface of the substrate, or may damage the barrier coating itself which may eventually damage the substrate, in either case resulting in damage to the electroactive device comprising the substrate. Minimizing the defects in the barrier coating may improve protection to the underlying substrate. Defects such as pinholes are typically deep and in some embodiments may extend across the thickness of the barrier coating, or in certain embodiments may just stop within the barrier coating. The pinhole defects that extend across the thickness of the barrier coating may expose the underlying substrate to attack by reactive species existing in the environment.

According to embodiments of the present invention at least one repair coating comprising a metal based compound is disposed on the barrier coating. As will be appreciated, the repair coating may advantageously reduce the effect of defects in the barrier coating, for example by reducing their number or their dimensions, or both. When reducing defects in the barrier coating that penetrate to the substrate surface, the repair coating may be in contact with the substrate as well as with the barrier coating. Illustrative metal based compounds comprise a metal, a metal oxide, a product of a metal oxide and a metal alkoxide, a condensation product of metal alkoxide, or any combination thereof. Illustrative metals comprise silver, functionalized silver, and like materials. Illustrative metal oxides comprise silica, titania, alumina, ceria, or any combination thereof. Illustrative metal alkoxides that may be disposed on the barrier coating comprise alkyl silanes, titanium alkoxides such as titanium isopropoxide or aluminum alkoxides such as aluminum isopropoxide. Illustrative alkyl silanes comprise trimethoxy methylsilane, tetraethoxy orthosilane, trisilanol isooctyl polyhedral oligomeric silsesquioxane, trisilanol phenyl polyhedral oligomeric silsesquioxane, or the like, or combinations thereof.

In some embodiments the metal oxide comprising the repair coating comprises metal oxide nanoparticles. Typical size of the metal oxide nanoparticles is in a range of from about 0.5 nm to about 100 nm. In one specific embodiment the size of the metal oxide nanoparticles is in a range of from about 0.5 nm to about 20 nm. In one embodiment a stable colloidal solution of the metal oxide nanoparticles is prepared and is disposed on the barrier coating. The preparation of the stable colloidal solution comprises dispersing the colloidal particles in a suitable solvent which may allow a colloid formation. The solvent may serve as a carrier for the metal oxide nanoparticles and may result in no adverse effect on the barrier coating, for example, peeling of the barrier coating. Illustrative solvents comprise an aromatic hydrocarbon, toluene, xylene, a glycol ether, ethylene glycol dimethyl ether, ethylene glycol diethyl ether, mixtures thereof, and the like. Other illustrative solvents comprise dimethyl sulfoxide, dimethyl formamide, ethyl acetate, propylene carbonate, mixtures thereof, and the like. In some embodiments the colloidal particles may be functionalized to improve the adhesive properties to the barrier coating. Alternatively, additives such as, but not limited to, methacryloxypropyltrimethoxysilane, glycidoxypropyltrimethoxysilane, aminopropylaminoethyltrimethoxysilane, tetraethoxysilane, or the like may be included in the colloidal solution to improve adhesion between the nanoparticles and the barrier coating.

In another embodiment a repair coating comprising a solution comprising metal alkoxide is prepared in a suitable solvent prior to application. In some embodiments the solvent is selected such that it may wet the surface of the barrier coating. Suitable solvents comprise xylene, toluene, isopropanol, tetrahydrofuran, and like solvents. Typically, the metal alkoxide undergoes hydrolysis and subsequent condensation to form a repair coating comprising the condensation product on the barrier coating. Illustrative condensation products of metal alkoxides that may constitute the repair coating comprise titania, silica, alumina, and the like. Additionally, the metal alkoxide solution may optionally comprise a catalyst such as, but not limited to, dibutyl tin dilaurate to increase the rate of condensation of the metal alkoxide on the barrier coating. In some embodiments a product of metal oxide and metal alkoxide may be provided on the barrier coating. The repair coating formed, according to embodiments of the present invention, may advantageously protect the underlying substrate.

Another embodiment of the invention is a method for making the barrier layer comprising barrier coating and repair coating. The repair coating comprising the colloidal solution or other appropriate repair coating solution or suspension may be disposed on the barrier coating through methods known in the art. In one embodiment the repair coating is disposed by spin coating on the barrier coating. Other methods of application may comprise spray coating or dip coating, or like methods. The repair coating may dry on the surface of the barrier coating resulting in a repair coating constituting metal oxide nanoparticles. In some embodiments the composite article comprising substrate, barrier coating and repair coating may optionally be annealed following application of repair coating.

In some embodiments the composite article comprising the substrate, the barrier coating, and the repair coating may be substantially transparent for applications requiring transmission of light. In the present context the term "substantially transparent" means allowing a transmission of light in one embodiment of at least about 50 percent, in another embodiment of at least about 80 percent, and in still another embodiment of at least about 90 percent of light in a selected wavelength range. The selected wavelength range can be in the visible region, infrared region, ultraviolet region, or any combination thereof of the electromagnetic spectrum, and in particular embodiments wavelengths can be in the range from about 300 nm to about 10 micrometers. In another particular embodiment the composite article exhibits a light transmittance of greater than about 80% and particularly greater than about 85% in a selected wavelength range between about 400 nm to about 700 nm.

In typical embodiments the composite article is flexible, and its properties do not significantly degrade upon bending. As used herein, the term "flexible" means being capable of being bent into a shape having a radius of curvature of less than about 100 centimeters.

Composite articles comprising substrate and barrier layer may be made by methods known in the art. In some embodiments composite articles may be made by a batch process, semi-continuous process, or continuous process. In one particular embodiment a composite article in embodiments of the invention may be made by a roll-to-roll process.

The composite article, according to embodiments of the invention, finds use in many devices or components such as, but not limited to, electroactive devices that are susceptible to reactive chemical species normally encountered in the environment. Illustrative electroactive devices comprise an electroluminescent device, a flexible display device including a liquid crystalline display (LCD), a thin film transistor LCD, a light emitting diode (LED), a light emitting device, an organic light emitting device (OLED), an optoelectronic device, a photovoltaic device, an organic photovoltaic device, an integrated circuit, a photoconductor, a photodetector, a chemical sensor, a biochemical sensor, a component of a medical diagnostic system, an electrochromic device, or any combination thereof. In another example the composite article as described in embodiments of the invention can advantageously be used in packaging of materials, such as food stuff, that are easily spoiled by chemical or biological agents normally existing in the environment.

Other embodiments of the invention comprise electroactive devices which comprise a composite article described in embodiments of the invention. In one illustrative example an electroactive device is a light emitting device comprising at least one organic electroluminescent layer sandwiched between two electrodes. The light emitting device further comprises a substrate and a barrier layer. The substrate may be flexible or substantially transparent, or both. The barrier layer comprises a barrier coating and a repair coating disposed on the barrier coating.

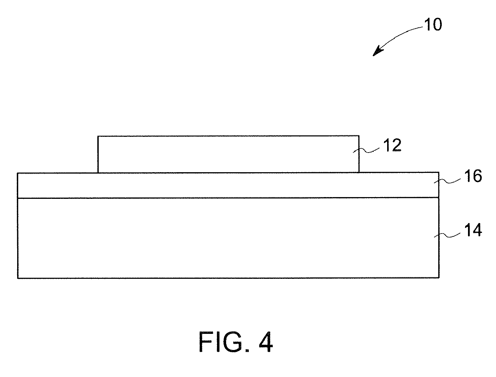

Figure 4 shows a composite article 10 in one embodiment of the invention. The composite article 10 comprises at least one organic electroluminescent layer 12 disposed on a substantially transparent substrate 14 and further comprises the barrier layer 16 disposed therein between as described above. The barrier layer 16 may be disposed or otherwise formed on either or both of the surfaces of the substrate 14 adjacent to the organic electroluminescent layer 12. In a particular embodiment the barrier layer 16 is disposed or formed on the surface of the substrate 14 adjacent to the organic electroluminescent layer 12. In other embodiments the barrier layer 16 may completely cover or encapsulate either the substrate 14 or the organic electroluminescent layer 12. In still other embodiments the barrier layer 16 may completely cover or encapsulate a composite article comprising a substrate 14 and an organic electroluminescent layer 12. In still other embodiments the barrier layer 16 may completely cover or encapsulate the device 10.

In a light emitting device comprising composite article 10, when a voltage is supplied by a voltage source and applied across the electrodes, light emits from the at least one organic electroluminescent layer 12. In one embodiment the first electrode is a cathode that may inject negative charge carriers into the organic electroluminescent layer 12. The cathode may be of a low work function material such as, but not limited to, potassium, lithium, sodium, magnesium, lanthanum, cerium, calcium, strontium, barium, aluminum, silver, indium, tin, zinc, zirconium, samarium, europium, alloys thereof, or the like, or mixtures thereof. The second electrode is an anode and is of a material having high work function such as, but not limited to, indium tin oxide, tin oxide, indium oxide, zinc oxide, indium zinc oxide, cadmium tin oxide, or the like, or mixtures thereof. The anode may be substantially transparent, such that the light emitted from the at least one organic electroluminescent layer 12 may easily escape through the anode. Additionally, materials used for the anode may be doped with aluminum species or fluorine species or like materials to improve their charge injection properties.

The thickness of the at least one organic electroluminescent layer 12 is typically in a range of about 50 nm to about 300 nm. The organic electroluminescent layer 12 may comprise a polymer, a copolymer, a mixture of polymers, or lower molecular weight organic molecules having unsaturated bonds. Such materials possess a delocalized pi-electron system, which gives the polymer chains or organic molecules the ability to support positive and negative charge carriers with high mobility. Mixtures of these polymers or organic molecules and other known additives may be used to tune the color of the emitted light. In some embodiments the organic electroluminescent layer 12 comprises a material selected from the group consisting of a poly(n-vinylcarbazole), a poly(alkylfluorene), a poly(paraphenylene), a polysilane, derivatives thereof, mixtures thereof, or copolymers thereof. In certain embodiments the organic electroluminescent layer 12 comprises a material selected from the group consisting of 1,2,3-tris[n-(4-diphenylaminophenyl) phenylaminobenzene, phenylanthracene, tetraarylethene, coumarin, rubrene, tetraphenylbutadiene, anthracene, perylene, coronene, aluminum-(picolylmethylketone)-bis[2,6-di(t-butyl)phenoxides], scandium-(4-methoxy-picolymethylketone)-bis(acetylacetonate), aluminum acetylacetonate, gallium acetylacetonate, and indium acetylacetonate. More than one organic electroluminescent layer 12 may be formed successively one on top of another, each layer comprising a different organic electroluminescent material that emits in a different wavelength range.

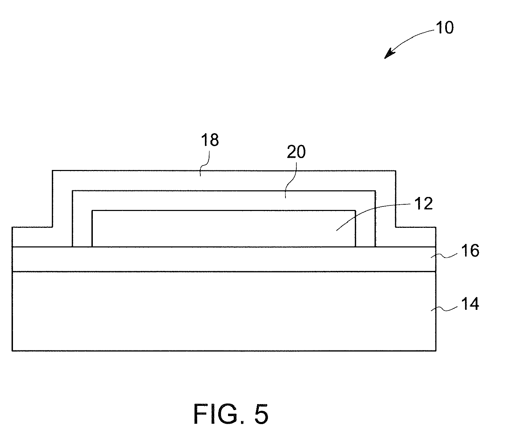

In some embodiments a reflective layer may be disposed on the organic electroluminescent layer to improve the efficiency of the device. Illustrative reflective layers comprise a material selected from the group consisting of a metal, a metal oxide, a metal nitride, a metal carbide, a metal oxynitride, a metal oxycarbide and combinations thereof. In other embodiments as shown in Figure 5, a reflective metal layer 18 may be disposed on the organic electroluminescent layer 12 to reflect any radiation emitted from the substantially transparent substrate 14 and direct such radiation toward the substrate 14 such that the total amount of radiation emitted in this direction is increased. Suitable metals for the reflective metal layer 18 comprise silver, aluminum, alloys thereof, and the like. A barrier layer 16 may be disposed on either side of the substrate 14. It may be desired to dispose the barrier layer 16 adjacent to the organic electroluminescent layer 12. The reflective metal layer 18 also serves an additional function of preventing diffusion of reactive chemical species, such as oxygen and water vapor, into the organic electroluminescent layer 12. It may be advantageous to provide a reflective layer thickness that is sufficient to substantially prevent the diffusion of oxygen and water vapor, as long as the thickness does not substantially reduce the flexibility of composite article 10. In one embodiment of the present invention one or more additional layers of at least one different material, such as a different metal or metal compound, may be formed on the reflective metal layer 18 to further reduce the rate of diffusion of oxygen and water vapor into the organic electroluminescent layer 12. In this case the material for such additional layer or layers need not be a reflective material. Compounds, such as, but not limited to, metal oxides, nitrides, carbides, oxynitrides, or oxycarbides, may be useful for this purpose.

In another embodiment of the composite article 10 an optional bonding layer 20 of a substantially transparent organic polymeric material may be disposed on the organic electroluminescent layer 12 before the reflective metal layer 18 is deposited thereon, also shown in Figure 5. Examples of materials suitable for forming the organic polymeric layer comprise polyacrylates such as polymers or copolymers of acrylic acid, methacrylic acid, esters of these acids, or acrylonitrile; poly(vinyl fluoride); poly(vinylidene chloride); poly(vinyl alcohol); a copolymer of vinyl alcohol and glyoxal (also known as ethanedial or oxaldehyde); polyethylene terephthalate, parylene (thermoplastic polymer based on p-xylene), and polymers derived from cycloolefins and their derivatives (such as poly(arylcyclobutene) disclosed in U.S. Patent Nos. 4,540,763 and 5,185,391. In one embodiment the bonding layer 20 material is an electrically insulating and substantially transparent polymeric material.

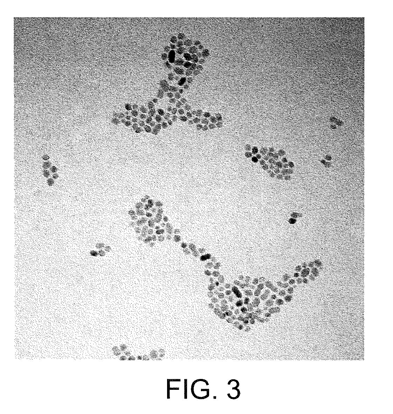

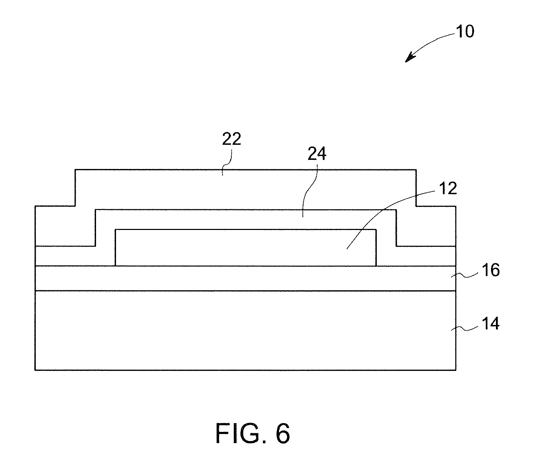

In another embodiment of the composite article 10 of the present invention a second barrier layer 24 is disposed on the organic electroluminescent layer 12 on the side away from the first substrate 14 to form a complete seal around the organic electroluminescent layer 12, as shown in Figure 6, wherein the second barrier layer 24 is disposed between the second substrate layer 22 and the electroluminescent layer 12. In some embodiments the second substrate 22 may comprise a polymeric material and particularly an organic polymeric material. The first barrier layer 16 may be disposed on either side of the first substrate 14. In one embodiment the first barrier layer 16 is disposed adjacent to the organic electroluminescent layer 12. In an alternative embodiment a reflective metal layer 18 may be disposed between the second barrier layer 24 and the organic electroluminescent layer 12 to provide even more protection to organic electroluminescent layer 12, wherein the order of layers in a modified embodiment of Figure 3 comprises, respectively, second substrate 22, second barrier layer 24, reflective metal layer 18, organic electroluminescent layer 12, first barrier layer 16, and first substrate 14. An optional bonding layer 20 may be present between reflective metal layer 18 and electroluminescent layer 12. In another embodiment the second barrier layer 24 may be deposited directly on the organic electroluminescent layer 12 and the second substrate 22 may be eliminated. In still another embodiment the second substrate 22 having the second barrier layer 24 can be disposed between organic electroluminescent layer 12 and the reflective metal layer 18, wherein the second substrate 22 is in contact with the reflective metal layer 18 and the second barrier layer 24 is in contact with the electroluminescent layer 12. An optional bonding layer 20 may be present between layers. This configuration may be desirable when it can offer some manufacturing or cost advantage, especially when the transparency of coated substrate is also substantial. The first barrier layer 16 and the second barrier layer 24 may be the same or different. The first substrate 14 and the second substrate 22 may be the same or different.

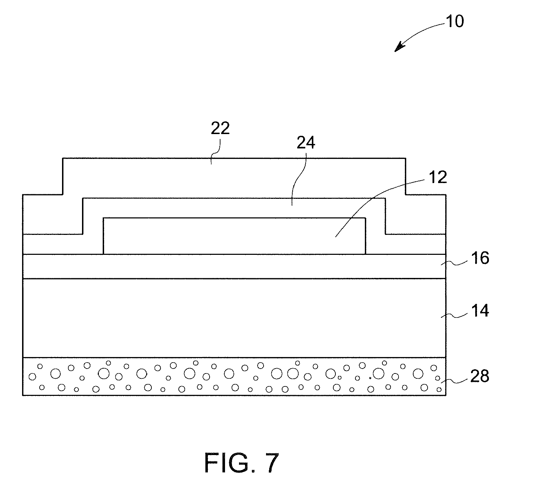

In another embodiment, as shown in Figure 7, the composite article 10 may further comprise a light scattering layer 28 disposed in the path of light emitted from a light emitting device comprising composite article 10, and also comprising first substrate 14, first barrier layer 16, organic electroluminescent layer 12, second barrier layer 24, and second substrate 22. The light scattering layer 28 typically comprises scattering particles of size in the range of from about 10 nm to about 100 micrometers. The scattering particles may be advantageously dispersed in a substantially transparent matrix disposed on the composite article. Illustrative light scattering materials comprise rutile, hafnia, zirconia, zircon, gadolinium gallium garnet, barium sulfate, yttria, yttrium aluminum garnet, calcite, sapphire, diamond, magnesium oxide, germanium oxide, or mixtures thereof. In some embodiments the light scattering layer 28 further comprises a photoluminescent material mixed with the scattering particles. The inclusion of such a photoluminescent material may provide a tuning of color of light emitted from a light emitting device comprising composite article 10. Many micrometer sized particles of oxide materials, such as zirconia, yttrium and rare-earth garnets, halophosphates or like materials may be used. Illustrative photoluminescent material may be selected from the group consisting of (Y₁₋ₓCeₓ)₃ Al₅O₁₂; (Y_{1-x-y}GdₓCe_{y})₃ Al₅O₁₂; (Y₁₋ₓCeₓ)₃ (Al_{1-y}Ga_{y}) O₁₂; (Y_{1-x-y}GdₓCe_{y}) (Al_{5-z}Ga_{z})O₁₂; (Gd₁₋ₓ Ceₓ)Sc₂Al₃O₁₂; Ca₈Mg(SiO₄)₄Cl₂:Eu²⁺,Mn²⁺; GdBO₃:Ce³⁺,Tb³⁺; CeMgAl₁₁O₁₉:Tb³⁺; Y₂SiO₅:Ce³⁺,Tb³⁺; BaMg₂Al₁₆O₂₇:Eu²⁺,Mn²⁺; Y₂O₃:Bi³⁺,Eu³⁺; Sr₂P₂O₇:Eu²⁺,Mn²⁺; SrMgP₂O₇:Eu²⁺,Mn²⁺; (Y,Gd)(V,B)O₄:Eu³⁺; 3.5MgO 0.5 MgF₂ GeO₂:Mn⁴⁺ (magnesium fluorogermanate); BaMg₂Al₁₆O₂₇:Eu²⁺; Sr₅(PO₄)₁₀Cl₂:Eu²⁺; (Ca,Ba,Sr)(Al,Ga)₂ S₄:Eu²⁺; (Ca, Ba, Sr)₅(PO₄)₁₀ (Cl,F)₂:Eu²⁺,Mn²⁺; Lu₃Al₅O₁₂:Ce³⁺; Tb₃Al₅O₁₂:Ce³⁺; and mixtures thereof; wherein 0≤x≤1,0≤y≤ 1,0≤z≤ 5 and x+y. ≤ 1. In some embodiments the light scattering layer 28 further comprises at least one organic photoluminescent material capable of absorbing at least a portion of electromagnetic radiation emitted by the organic electroluminescent layer 12 and emitting electromagnetic radiation in the visible range.

Furthermore, one or more additional layers may be included in any light emitting device comprising composite article 10 between one of the two electrodes and the organic electroluminescent layer 12 to perform at least one function selected from the group consisting of electron injection enhancement, hole injection enhancement, electron transport enhancement, and hole transport enhancement.

Barrier layers comprising barrier coating with repair coating in embodiments of the invention typically exhibit barrier properties which comprise a low water vapor transmission rate and a low oxygen transmission rate. In some embodiments barrier layers of the invention have a water vapor transmission rate in one embodiment of less than about 1x10⁻² grams per square meter per day (g/m²/day), and in another embodiment of less than about 1x10⁻⁴ grams per square meter per day (g/m²/day), as measured at 25°C and with a gas having 50 percent relative humidity. Barrier layers of the invention have an oxygen transmission rate in one embodiment of less than about 0.1 cubic centimeters per square meter per day (cm³/m²/day), in another embodiment of less than about 0.5 cm³/m²/day, and in still another embodiment of less than about 1 cm³/m²/day as measured at 25°C and with a gas containing 21 volume percent oxygen. In some embodiments the barrier layers were tested for their barrier properties using at least one of two tests, the edge seal calcium test and the oxygen plasma etch test. The edge seal calcium test is based on the reaction of calcium with water vapor and is described, for example, by A.G. Erlat et al. in "47th Annual Technical Conference Proceedings - Society of Vacuum Coaters", 2004, pp. 654-659, and by M.E. Gross et al. in "46th Annual Technical Conference Proceedings - Society of Vacuum Coaters", 2003, pp. 89-92. In a representative embodiment of the test, a calcium test cell is fabricated by evaporating a 50 nm thick calcium layer on top of a cleaned, 50 millimeter (mm) by 75 mm glass slide. The glass slide is then sealed using an epoxy to a second clean glass slide in an argon glove box. In some embodiments the glass slide is sealed to the substrate having the barrier layer. In the edge seal calcium test the barrier layer is provided on the opposite side of the second clean glass surface such that the barrier layer is not in contact with the calcium coating. The barrier layer is not in direct contact with the calcium surface as they are separated using an epoxy layer along the sides of the glass. The calcium test cell is placed between a light emitting diode (LED) source and a photodetector in a temperature and humidity controlled environment. The test is conducted at 23°C at a relative humidity of 50%. As oxygen and water vapor permeate through the substrate, the calcium within the cell reacts to form oxide and hydroxide, respectively. As water permeation progresses, the calcium layer becomes thinner and transparent, thus lowering the optical density. The light transmission is continuously measured at a wavelength of 880 nm, and the change in optical density as a function of time can be used to calculate the water vapor transmission rate which is a measure of barrier properties. The detection limit using this method is as low as about 10⁻⁶ g/m²/day to about 10⁻⁵ g/m²/day, and this value is to a certain extent determined by the effectiveness of the edge epoxy seal used as a separation between the barrier layer and the calcium.

The oxygen plasma etch test is a qualitative test and is faster than the edge seal calcium test. Although the oxygen plasma etch test does not directly measure barrier properties, it gives more detailed data regarding defects such as a defect location, density and size of pin hole defects in the barrier layer. In this test, the coating is exposed to oxygen plasma in a PECVD chamber and reactive oxygen species are allowed to penetrate through the defects in the barrier layer. The subsequent expansion of the etched defect area due to oxygen etching are imaged using an optical microscope. In one example of the oxygen plasma etch test a barrier coating comprising silicon nitride is deposited as a single layer on a polycarbonate substrate having a top coat of UVHC3000 (a hard coat silicone comprising an organo-functionalized colloidal silica in a UV curable acrylate mix obtained from GE Advanced Materials). The respective repair coating is disposed over the silicon nitride layer. The substrate is placed on the bottom electrode of the PECVD reactor and is exposed to oxygen plasma. The reactive oxygen species in the oxygen plasma penetrate through the defects in the coatings and etch the underlying polycarbonate substrate. The expansion of the etched area is monitored under an optical microscope at intervals of about 2 hours and the etch rate is obtained.

Without further elaboration, it is believed that one skilled in the art can, using the description herein, utilize the present invention to its fullest extent. The following examples are included to provide additional guidance to those skilled in the art in practicing the claimed invention. The examples provided are merely representative of the work that contributes to the teaching of the present application. Accordingly, these examples are not intended to limit the invention, as defined in the appended claims, in any manner.

### EXAMPLE 1

Preparation of silicon oxide precursors from trimethoxy methylsilane: A stock solution of trimethoxy methylsilane (CH₃Si[OCH₃]₃) (MTMS) was prepared by dissolving 0.25 grams (g) of trimethoxy methylsilane in 25 milliliters (ml) of xylene. Stock solutions of catalysts were prepared by dissolving either 0.1g of potassium trimethylsilanolate (KOSi[CH₃]₃) or 0.1g of dibutyl tin dilaurate ([C₄H₉]₂Sn[OCO[CH₂]₁₀CH₃]₂), in 25 ml of xylene. Into 1 ml of MTMS stock solution a single drop of water along with 0.2 ml of respective catalyst stock solution was added. The rate of condensation of MTMS was followed by measuring the rate of disappearance of MTMS using gas chromatography which indicated that dibutyl tin dilaurate was a better catalyst than potassium trimethylsilanolate for condensation of MTMS.

The solution of MTMS in xylene along with dibutyl tin dilaurate catalyst solution is spin coated at 5000 rotations per minute (rpm) for a period of 60 seconds onto a silicon nitride surface coated on a polycarbonate substrate. The coated polycarbonate substrate comprising SiN barrier coating with the MTMS repair coating is tested for barrier properties using the edge seal calcium test. The barrier properties of the coated polycarbonate substrate show improved environmental resistance as compared to the coated polycarbonate substrate with no MTMS repair coating.

### EXAMPLE 2

Preparation of silicon oxide precursors from tetraethoxy orthosilane: A stock solution was prepared by dissolving 0.1 g of dibutyl tin dilaurate in 10g of tetraethoxy orthosilane (Si[OC₂H₅]₄) (TEOS). 0.5g of the stock solution was dissolved in 50 ml of xylene to form a clear solution.

A 125 microns thick polycarbonate film on a hoop was coated with 3,4-epoxycyclohexylmethyl-3,4-epoxycyclohexylcarboxylate and then plasma coated with silicon nitride as barrier coating. The film was then cut from the hoop and air cleaned. It was then cemented to a glass slide. The resultant clear solution containing TEOS was spin coated at 3000 rpm for 30 seconds onto the silicon nitride surface to form a repair coating. The thickness of the coating was obtained from ellipsometry, profilometry and dynamic light scattering measurements and the results for duplicate samples are listed in Table 3. For the oxygen plasma etching test, the substrate was coated with UVHC3000 following application of the repair coating. The microscopy images obtained for the oxygen plasma etch test indicated that the substrate comprising SiN barrier coating with the repair coating showed greater protection against oxygen etch compared to a control sample comprising SiN barrier coating with only a coating of UVHC 3000 but no repair coating.

### EXAMPLE 3

Preparation of silicon oxide precursors from trisilanol isooctyl polyhedral oligomeric silsesquioxane: 5g of trisilanol isooctyl polyhedral oligomeric silsesquioxane (trisilanol isooctyl-POSS, Hybrid Chemicals) was dissolved in 25 ml of tetrahydrofuran (THF). A stock solution of catalyst was prepared by dissolving 0.1 g of tetrabutylammonium fluoride ([C₄H₉]₄NF) in 25 ml of THF. Into 5 ml of the trisilanol isooctyl-POSS solution 0.1 ml of the catalyst solution was added.

Portions of the resultant clear solution were separately spin coated at 3000 rpm for 30 seconds onto a silicon nitride surface coated onto either a polycarbonate substrate or a PET substrate. Each substrate comprising SiN barrier coating with repair coating is tested for barrier properties and shows improved environmental resistance compared to respective control samples without repair coating.

### EXAMPLE 4

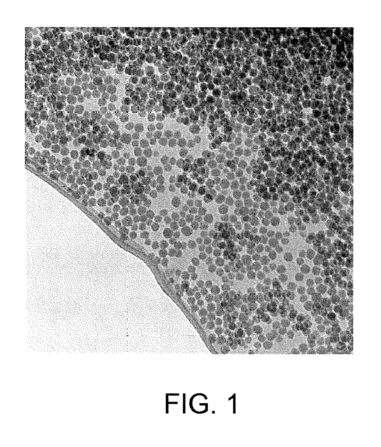

Preparation of stable colloidal solution of silica in xylene: About 15g of AS30 (commercially available aqueous colloidal silica solution from DuPont) and 7.9g of trimethoxy phenylsilane (C₆H₅Si[OCH₃]₃) was added to 25.3g of isopropanol and 52.7g of xylene. Water, isopropanol, and xylenes form a ternary azeotrope to which excess xylene was added to exceed the concentration of the azeotrope. The mixture was heated to 78°C to remove the ternary azeotrope and a clear liquid (46.3g), mostly of xylene remained which contained about 23.9% solids. Transmission electron microscopy image of the colloid (Figure 1) shows monodisperse particles with a size of about 20 nm.

A 125 microns thick polycarbonate film on a hoop was coated with 3,4-epoxycyclohexylmethyl-3,4-epoxycyclohexylearboxylate and then plasma coated with silicon nitride as barrier coating. The film was then cut from the hoop and air cleaned. It was then cemented to a glass slide. The colloidal solution containing silica was spin coated onto the silicon nitride surface. The thickness of the coating was obtained from ellipsometry, profilometry and dynamic light scattering measurements and the results for duplicate samples are listed in Table 3. For the oxygen plasma etching test the substrate was coated with UVHC3000 following application of the repair coating. The microscopy images obtained for the oxygen plasma etch test indicated that the substrate comprising SiN barrier coating with the repair coating showed greater protection against oxygen etch compared to a control sample comprising SiN barrier coating with only a coating of UVHC 3000 but no repair coating.

### EXAMPLE 5

Preparation of stable colloidal solution of silica in xylene: Example 5 was prepared the same way as Example 4 but AS40 (commercially available aqueous colloidal silica solution) was used instead of AS30. The resultant solution was spin coated onto a silicon nitride surface coated on a polycarbonate substrate. The substrate comprising SiN barrier coating with repair coating is tested for barrier properties and shows improved environmental resistance as compared to a substrate comprising SiN barrier coating having no silica repair coating.

### EXAMPLE 6

Preparation of titanium oxide precursor: 1g of titanium isopropoxide (Ti[OC₃H₇]₄) was mixed with 10mg of dibutyl tin dilaurate in 10 ml of xylene to form a clear solution.

A 125 microns thick polycarbonate film on a hoop was coated with 3,4-epoxycyclohexyl methyl 3,4-epoxycyclohexylcarboxylate and then plasma coated with silicon nitride. The film was then cut from the hoop and air cleaned. It was then cemented to a glass slide. The clear solution containing titanium isopropoxide was spin coated at 3000 rpm for 30 seconds onto the silicon nitride coated surface of the polycarbonate substrate. The thickness of the coating was obtained from ellipsometry, profilometry and dynamic light scattering measurements and the results for duplicate samples are listed in Table 3. The substrate comprising SiN barrier coating with repair coating was tested for barrier properties using the edge seal calcium test and the results for duplicate samples are given in Table 4. The data show that the coated substrate comprising repair coating has improved environmental resistance compared to a control sample without repair coating. For the oxygen plasma etching test the substrate was coated with UVHC3000 following application of the repair coating. The microscopy images obtained for the oxygen plasma etch test indicated that the substrate comprising SiN barrier coating with the repair coating showed greater protection against oxygen etch compared to a control sample comprising SiN barrier coating with only a coating of UVHC 3000 but no repair coating.

### EXAMPLE 7

Preparation of titanium dioxide colloids using sebacic acid: 60g of titanium tetraethylhexanoate (Ti[2-ethylhexanoate]₄) and 5.6g of sebacic acid (HOOC[CH₂]₈COOH), were combined in a 300 ml Parr bomb constructed of HASTELLOY C alloy. About 4 ml of water was placed in a separate 2-dram vial over the above mixture. The bomb was then sealed and subjected to five cycles of degassing and nitrogen purging. The temperature of the bomb was raised to 225°C under nitrogen. The reaction was allowed to continue for three hours at 225°C with constant stirring. After cooling, the contents were subjected to centrifugation to remove any liquid, and the paste was recovered for use in preparing the colloid solution.

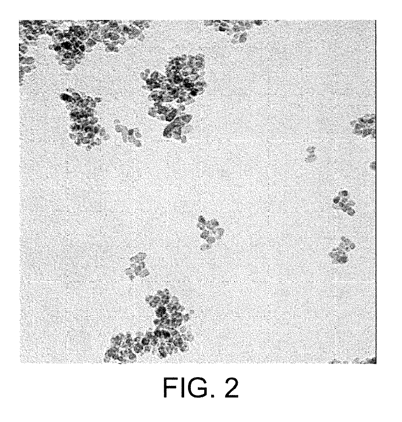

The resultant paste (5g) was combined with 0.9g of trimethoxy hexadecylsilane (H₃C[CH₂]₁₅Si[OCH₃]₃) in 25 ml of ethyleneglycol dimethylether (DME). The solution was then refluxed with continued stirring for 17 hours to form a translucent, stable colloidal solution. The colloidal solution had 9.8% solids by weight. Transmission electron microscopy (TEM) image (Figure 2) of the colloidal solution shows colloidal particles of size in the range of about 3.3 nm to about 61.4 nm. The ratio of titanium tetraethylhexanoate to sebacic acid to water was varied to obtain nanoparticles of different sizes, and the results are listed in Table 1.

**TABLE 1.**

| | | | | | |
|---|---|---|---|---|---|
| Ratio of Ti:COOH:H₂O | Mean size (nm) | Std dev (nm) | Min size (nm) | Max size (nm) | Aspect ratio |
| 1:1:4 | 8.2 | 2.6 | 4.1 | 24.6 | 1.1 |
| 1:1:1 | 16.3 | 5.4 | 7 | 61.4 | 2.1 |
| 1:0.25:4 | 7.8 | 2.3 | 3.3 | 19 | 1.1 |
| 1:0.25:1 | 13.5 | 4.4 | 5.5 | 41.2 | 1.5 |
| 1:0.5:2 | 8.6 | 2.6 | 4.4 | 23 | 1.2 |

The colloidal solution of about 9.8 % by weight of solids is spin coated onto a silicon nitride surface plasma deposited on a polycarbonate substrate. The polycarbonate substrate comprising SiN barrier coating with repair coating is tested for barrier properties using the edge seal calcium test and shows improved environmental resistance compared to a control substrate having no repair coating.

### EXAMPLE 8

Preparation of titanium dioxide (titania) colloids using 2-ethylhexanoic acid: 60g of titanium tetraethylhexoxide (TiO₂[ethylhexoxide]₄) and 8g of 2-ethylhexanoic acid were combined in a 300 ml Parr bomb. In a separate 2 dram glass vial, 4 ml of water was taken and placed over the titanium tetraethylhexoxide/ethylhexanoic acid solution. The bomb was then sealed, after degassing and purging it with nitrogen about 5 times. The temperature of the bomb was raised to 225°C. The reaction was allowed to continue for three hours at 225°C with constant stirring. The bomb was cooled to ambient temperature and the entire contents of the bomb were subjected to centrifugation at 5000 rpm for 10 minutes. The eluent of about 46.5g were discarded and the paste (19.48g) was retained for further processing.

The resultant paste (5g) was combined with 0.9g of trimethoxy hexadecylsilane in 25 ml of ethyleneglycol dimethylether. The solution was then refluxed with continued stirring for 12 hours to form a translucent, stable colloidal solution. The colloidal solution had 9.1% solids by weight. Transmission electron microscopy (TEM) (Figure 3) of the colloidal solution shows particles of size in the range of about 3.6 nm to about 34.9 nm. The ratio of titanium tetraethylhexoxide to 2-ethylhexanoic acid to water was varied to obtain nanoparticles of different sizes and the results are listed in Table 2.

**TABLE 2.**

| | | | | | | |
|---|---|---|---|---|---|---|
| Ratio of Ti:COOH:H2O | Temp (°C) | Mean size (nm) | Std dev (nm) | Min size (nm) | Max size (nm) | Aspect ratio |
| 1:0.5:2 | 225 | 7.4 | 1.4 | 4 | 13.4 | 1.4 |
| 1:0.5:2 | 275 | 7.2 | 0.8 | 4.6 | 10.9 | 1.4 |
| 1:1:1 | 225 | 7 | 0.7 | 4.6 | 11.1 | 1.4 |
| 1:1:1 | 275 | 9.4 | 3 | 3.6 | 34.9 | 1.7 |

A 125 microns thick polycarbonate film on a hoop was coated with 3,4-epoxycyclohexylmethyl-3,4-epoxycyclohexylcarboxylate and then plasma coated with silicon nitride. The film was then cut from the hoop and air cleaned. It was then cemented to a glass slide. The colloidal solution containing stable titanium dioxide prepared using a 1:0.5:2 solution of titanium tetraethylhexoxide to ethylhexanoic acid to water was diluted to about one tenth and then spin coated onto the silicon nitride surface. The thickness of the coating was obtained from ellipsometry, profilometry and dynamic light scattering measurements and the results for duplicate samples are listed in Table 3. The substrate comprising SiN barrier coating with repair coating was tested for barrier properties using the edge seal calcium test and the results for duplicate samples are shown in Table 4. The data show that the coated substrate comprising SiN barrier coating with repair coating has improved environmental resistance compared to a control sample without repair coating. For the oxygen plasma etching test, the substrate was coated with UVHC3000 following application of the repair coating. The microscopy images obtained for the oxygen plasma etch test indicated that the substrate comprising SiN barrier coating with the repair coating showed greater protection against oxygen etch compared to a control sample comprising SiN barrier coating with only a coating of UVHC 3000 but no repair coating.

### EXAMPLE 9

Preparation of titanium dioxide, tetraethoxy orthosilane solution: The titanium dioxide solution in ethyleneglycol dimethylether was prepared as in Example 8. About 54 ml of the solution was combined with 3g of tetraethoxy orthosilane and the resultant mixture was spin coated onto a silicon nitride surface coated onto a polycarbonate substrate. The spin coated substrate comprising SiN barrier coating with repair coating was tested for barrier properties using the edge seal calcium test and the results for duplicate samples are shown in Table 4. The data show that the coated substrate comprising SiN barrier coating with repair coating has improved environmental resistance compared to a control sample without repair coating.

### EXAMPLE 10

Preparation of stable colloidal solution of aluminum oxide in xylenes: 50g of aluminum-tri-sec-butoxide (Al[OCH(CH₃)C₂H₅]₃) and 14.6g of 2-ethylhexanoic acid were combined in a 300 ml Parr bomb. In a separate 2 dram glass vial, 7.2g of water was taken and placed over the aluminum-tri-sec-butoxide /ethylhexanoic acid solution. The bomb was then sealed, after degassing and purging it with nitrogen about 5 times. The temperature of the bomb was raised to 225°C. The reaction was allowed to continue for three hours at 225°C with constant stirring. The bomb was cooled to ambient temperature and the entire contents of the bomb were subjected to centrifugation at 5000 rpm for 10 minutes to obtain a white paste (29.7g).

The resultant white paste (5g) was combined with 1.0g of trimethoxy hexadecylsilane in 25 ml of xylene in a 100 ml round bottom flask. The solution was then refluxed with continued stirring for 1 hour to form a white, stable colloidal solution. The colloidal solution had 7.7% solids by weight. The resultant mixture was spin coated onto a silicon nitride surface deposited on a polycarbonate substrate. The thickness of the coating was obtained from ellipsometry, profilometry and dynamic light scattering measurements and the results for duplicate samples are listed in Table 3. For the oxygen plasma etching test, the substrate was coated with UVHC3000 following application of the repair coating. The microscopy images obtained for the oxygen plasma etch test indicated that the substrate comprising SiN barrier coating with the repair coating showed greater protection against oxygen etch compared to a control sample comprising SiN barrier coating with only a coating of UVHC 3000 but no repair coating.

### EXAMPLE 11

Preparation of stable colloidal solution of aluminum oxide in ethyleneglycol dimethylether: The paste obtained from the procedure as given in Example 10 was combined with 0.9g of trimethoxy hexadecylsilane in 25 ml of ethyleneglycol dimethylether in a 100 ml round bottom flask. The solution was then refluxed with continued stirring for 12 hours to form a white, stable colloidal solution. The colloidal solution had 9.1% solids by weight. The resultant mixture was spin coated onto a silicon nitride surface deposited on a polycarbonate substrate. The substrate comprising SiN barrier coating with repair coating was tested for barrier properties using the edge seal calcium test and the results for duplicate samples are shown in Table 4. The data show that the coated substrate comprising SiN barrier coating with repair coating has improved environmental resistance compared to a control sample without repair coating.

**TABLE 3.**

| Coating | | Profliometer (nm) | Ellipsometer (nm) | DLS (nm) |
|---|---|---|---|---|
| Example 2 | Batch 1 | --- | 2 | --- |
| | Batch 2 | --- | 2 | --- |
| Example 4 | Batch 1 | 8-23 | 12 | --- |
| | Batch 2 | --- | 12 | --- |
| | Batch 1 | 100-140 | 100 | --- |
| Example 6 | Batch 2 | 130-190 | 100 | --- |
| Example 8 | Batch 1 | 7-69 | 25 | 73 |
| | Batch 2 | 2-38 | 25 | --- |
| Example 10 | Batch 1 | 89-220 | 120 | --- |
| | Batch 2 | 89-180 | 120 | --- |

**TABLE 4.**

| Repair Coating | Water Vapor Transmission Rate (g/m²/day) |
|---|---|
| none/ Glass control 1 | 1.8E-05 |
| none/ Glass control 2 | 3.5E-05 |
| none/ SiN control 1 | 2.3E-04 |
| none/ SiN control 2 | 1.7E-04 |
| Example 6-1 | 9.6E-04 |
| Example 6-2 | 5.2E-05 |
| Example 7-1 | 4.8E-05 |
| Example 7-2 | 9.5E-06 |
| Example 8-1 | 9.3E-05 |
| Example 8-2 | 8.4E-05 |
| Example 9-1 | 6.4E-05 |
| Example 9-2 | 5.2E-05 |
| Example 11-1 | 8.9E-05 |
| Example 11-2 | 1.4E-04 |

While only certain features of the invention have been illustrated and described herein, many modifications and changes will occur to those skilled in the art.
For completeness, various aspects of the invention are now set out in the following numbered clauses.
1. A composite article comprising:
   a substrate having a surface; and
   a barrier layer disposed on a surface of the substrate;
   wherein the barrier layer comprises a barrier coating and a repair coating disposed on the barrier coating, wherein the repair coating comprises a metal based compound.
2. The composite article of clause 1, wherein the substrate comprises an organic polymeric resin, a glass, a metal, a ceramic, or any combination thereof.
3. The composite article of clause 2, wherein the organic polymeric resin comprises a polyethylene terephthalate, a polyacrylate, a polycarbonate, a silicone, an epoxy resin, a silicone-functionalized epoxy resin, a polyester, a polyimide, a polyetherimide, a polyethersulfone, a polyethylene naphthalate, a polynorbornene, or a poly(cyclic olefin).
4. The composite article of clause 1, wherein the barrier coating is selected from the group consisting of organic materials, inorganic materials, ceramic materials, metals, and any combination thereof.
5. The composite article of clause 4, wherein the barrier coating is selected from the group consisting of oxides, nitrides, carbides, and borides of elements of Groups IIA, IIIA, IVA, VA, VIA, VIIA, IB, IIB, metals of Groups IIIB, IVB, VB, rare earth elements, and any combination thereof.
6. The composite article of clause 1, wherein the metal based compound comprises a metal oxide, a metal alkoxide or any combination thereof.
7. The composite article of clause 6, wherein the metal oxide comprises silica, titania, alumina or any combination thereof.
8. The composite article of clause 6, wherein the metal oxide comprises nanoparticles having an average size in the range of from about 0.5 nm to about 100 nm.
9. The composite article of clause 6, wherein the metal based compound comprises a condensation product of a metal alkoxide, wherein the metal alkoxide comprises trimethoxy methylsilane, tetraethoxy orthosilane, trisilanol isooctyl polyhedral oligomeric silsesquioxane, trisilanol phenyl polyhedral oligomeric silsesquioxane, titanium isopropoxide or any combination thereof.
10. The composite article of clause 1, wherein the barrier layer has a water vapor transmission rate through the barrier layer of less than about 1 × 10⁻² g/m²/day, as measured at 25°C and with a gas having 50 percent relative humidity.
11. The composite article of clause 1, having a light transmittance of greater than about 80% in a selected wavelength range between about 400 nanometers to about 700 nanometers.
12. The composite article of clause 1, wherein the barrier layer encapsulates the substrate and one or more other layers.
13. The composite article of clause 1, further comprising at least one planarizing layer.
14. An electroactive device comprising the composite article of clause 1.
15. The electroactive device of clause 14, comprising a flexible display device, a liquid crystalline display (LCD), a thin film transistor LCD, an electroluminescent device, a light emitting diode, a light emitting device, an organic light emitting device, a photovoltaic device, an organic photovoltaic device, a photoconductor, a photodetector, an optoelectronic device, an integrated circuit, a chemical sensor, a biochemical sensor, a component of a medical diagnostic system, an electrochromic device, or any combination thereof.
16. The electroactive device of clause 14, which is encapsulated by the barrier layer.
17. A packaging material comprising the composite article of clause 1.
18. A method of making a composite article comprising the steps of:
   (i) providing a flexible substrate having a surface;
   (ii) depositing a barrier coating on the surface of the substrate; and
   (iii) disposing a metal based compound on the barrier coating to form a repair coating.
19. The method of clause 18, wherein the barrier coating is deposited using plasma enhanced chemical vapor deposition, radio frequency plasma enhanced chemical vapor deposition, expanding thermal plasma-enhanced chemical vapor deposition, sputtering, reactive sputtering, electron cyclotron resonance plasma-enhanced chemical vapor deposition, inductively coupled plasma-enhanced chemical vapor deposition, evaporation, atomic layer deposition, or any combination thereof.
20. The method of clause 18, wherein the metal based compound is disposed by spin coating, dip coating, spray coating or any combination thereof.
21. The method of clause 18, wherein the metal based compound is disposed as a colloidal solution comprising a metal oxide, wherein the metal oxide comprises silica, titania, alumina or any combination thereof.
22. The method of clause 21, wherein the repair coating is formed by drying the colloidal solution comprising the metal oxide to form metal oxide nanoparticles on the barrier coating.
23. The method of clause 18, wherein the metal based compound is disposed as a solution comprising a metal alkoxide, wherein the metal alkoxide comprises trimethoxy methylsilane, tetraethoxy orthosilane, trisilanol isooctyl polyhedral oligomeric silsesquioxane, trisilanol phenyl polyhedral oligomeric silsesquioxane, titanium isopropoxide or any combination thereof.
24. The method of clause 23, wherein the solution comprising metal alkoxide further comprises a catalyst.
25. The method of clause 23, wherein the repair coating is formed by condensation reaction of the metal alkoxide to form a condensation product of the metal alkoxide on the barrier coating.
26. The method of clause 18, which further comprises providing a planarizing layer on the substrate.
27. The method of clause 18, which employs a roll-to-roll process.
28. An article made by the method of clause 18.
29. A light emitting device comprising:
   a flexible, substantially transparent substrate having a surface;
   a barrier layer disposed on a surface of the substrate;
   and at least one organic electroluminescent layer disposed between two electrodes;
   wherein the barrier layer comprises a barrier coating and a repair coating disposed on the barrier coating, wherein the repair coating comprises a metal based compound.
30. The light emitting device of clause 29, wherein the substrate comprises a polyethylene terephthalate, a polyacrylate, a polycarbonate, a silicone, an epoxy resin, a silicone-functionalized epoxy resin, a polyester, a polyimide, a polyetherimide, a polyethersulfone, a polyethylene naphthalate, a polynorbornene, or a poly(cyclic olefin).
31. The light emitting device of clause 29, wherein the barrier coating is selected from the group consisting of organic materials, inorganic materials, ceramic materials, metals and any combination thereof.
32. The light emitting device of clause 31, wherein the barrier coating is selected from the group consisting of oxides, nitrides, carbides, and borides of elements of Groups IIA, IIIA, IVA, VA, VIA, VIIA, IB, IIB, metals of Groups IIIB, IVB, VB, rare earth elements, and any combination thereof.
33. The light emitting device of clause 29, wherein the metal based compound comprises a metal oxide, a metal alkoxide, a condensation product of the metal alkoxide, or any combination thereof.
34. The light emitting device of clause 29, further comprising a reflective layer disposed on the organic electroluminescent layer, wherein the reflective layer comprises a material selected from the group consisting of metals, metal oxides, metal nitrides, metal carbides, metal oxynitrides, metal oxycarbides, and combinations thereof.
35. The light emitting device of clause 29, wherein the organic electroluminescent layer comprises a material selected from the group consisting of a poly(n-vinylcarbazole), a poly(alkylfluorene), a poly(paraphenylene), a polysilane, derivatives thereof, mixtures thereof, and copolymers thereof.
36. The light emitting device of clause 29, wherein the organic electroluminescent layer comprises a material selected from the group consisting of 1,2,3-tris[n-(4-diphenylaminophenyl) phenylamino] benzene, phenylanthracene, tetraarylethene, coumarin, rubrene, tetraphenylbutadiene, anthracene, perylene, coronene, aluminum-(picolylmethylketone)-bis[2,6-di(t-butyl)phenoxides], scandium-(4-methoxypicolymethylketone0-bis(acetylacetonate), aluminum acetylacetonate, gallium acetylacetonate, and indium acetylacetonate.
37. The light emitting device of clause 29, further comprising a light scattering layer, wherein the light scattering layer comprises scattering particles dispersed in a substantially transparent matrix.
38. The light emitting device of clause 37, wherein the light scattering layer further comprises a photoluminescent material mixed with the scattering particles, wherein the photoluminescent material is selected from the group consisting of (Y₁₋ₓCeₓ)₃ Al₅O₁₂; (Y_{1-x-y}GdₓCe_{y})₃ Al₅O₁₂; (Y₁₋ₓCeₓ)₃ (Al_{1-y}Ga_{y}) O₁₂; (Y_{1-x-y}GdₓCe_{y}) (Al_{5-z}Ga_{z})O₁₂; (Gd₁₋ₓ Ceₓ)Sc₂Al₃O₁₂; Ca₈Mg(SiO₄)₄Cl₂:Eu²⁺,Mn²⁺; GdBO₃:Ce³⁺,Tb³⁺; CeMgAl₁₁O₁₉:Tb³⁺; Y₂SiO₅:Ce³⁺,Tb³⁺ ; BaMg₂Al₁₆O₂₇:Eu²⁺,Mn²⁺; Y₂O₃:Bi³⁺,Eu³⁺; Sr₂P₂O₇:Eu²⁺,Mn²⁺; SrMgP₂O₇:Eu²⁺,Mn²⁺; (Y,Gd)(V,B)O₄:Eu³⁺; 3.5MgO 0.5 MgF₂ GeO₂:Mn⁴⁺ (magnesium fluorogermanate); BaMg₂Al₁₆O₂₇:Eu²⁺; Sr₅(PO₄)₁₀Cl₂:Eu²⁺; (Ca,Ba,Sr)(Al,Ga)₂ S₄:Eu²⁺; (Ca, Ba, Sr)₅(PO₄)₁₀ (Cl,F)₂:Eu²⁺,Mn²⁺; Lu₃Al₅O₁₂:Ce³⁺; Tb₃Al₅O₁₂:Ce³⁺; and mixtures thereof; wherein 0 ≤ x ≤ 1, 0 ≤ y ≤ 1, 0 ≤ z ≤ 5 and x+y. ≤ 1.
39. The light emitting device of clause 37, further comprising at least one organic photoluminescent material dispersed within the light scattering layer, wherein the organic photoluminescent material is capable of absorbing at least a portion of electromagnetic radiation emitted by the organic electroluminescent layer and emitting electromagnetic radiation in a visible range.
40. The light emitting device of clause 29, wherein the organic electroluminescent structure further comprises at least one additional layer disposed between one of the two electrodes and the organic electroluminescent layer, wherein the additional layer performs at least one function selected from the group consisting of electron injection enhancement, electron transport enhancement, hole injection enhancement, and hole transport enhancement.
41. A composite article comprising:
   a substrate having a surface; and
   a barrier layer disposed on a surface of the substrate;
   wherein the barrier layer comprises a barrier coating and at least one repair coating disposed on the barrier coating, wherein the barrier coating is selected from the group consisting of oxides, nitrides, carbides, and borides of elements of Groups IIA, IIIA, IVA, VA, VIA, VIIA, IB, IIB, metals of Groups IIIB, IVB, VB, rare earth elements, and any combination thereof;
   wherein the repair coating comprises either (i) silica, titania, alumina or any combination thereof or (ii) metal oxide nanoparticles having an average size in the range of from about 0.5 nm to about 100 nm or (iii) a condensation product of a metal alkoxide, wherein the metal alkoxide comprises trimethoxy methylsilane, tetraethoxy orthosilane, trisilanol isooctyl polyhedral oligomeric silsesquioxane, trisilanol phenyl polyhedral oligomeric silsesquioxane, titanium isopropoxide or any combination thereof;
   wherein the barrier layer has a water vapor transmission rate through the barrier layer of less than about 1x10⁻² g/m²/day, as measured at 25°C and with a gas having 50 percent relative humidity, and
   wherein the composite article has a light transmittance of greater than about 80% in a selected wavelength range between about 400 nanometers to about 700 nanometers.
42. An electroactive device or a packaging material comprising the composite article of clause 41.
43. A barrier layer disposed on a surface of a substrate; wherein the barrier layer comprises a barrier coating and a repair coating comprising a metal based compound disposed on the barrier coating,
wherein the barrier coating is selected from the group consisting of oxides, nitrides, carbides, and borides of elements of Groups IIA, IIIA, IVA, VA, VIA, VIIA, IB, IIB, metals of Groups IIIB, IVB, VB, rare earth elements, and any combination thereof;
wherein the repair coating comprises either (i) silica, titania, alumina or any combination thereof or (ii) metal oxide nanoparticles having an average size in the range of from about 0.5 nm to about 100 nm or (iii) a condensation product of a metal alkoxide, wherein the metal alkoxide comprises trimethoxy methylsilane, tetraethoxy orthosilane, trisilanol isooctyl polyhedral oligomeric silsesquioxane, trisilanol phenyl polyhedral oligomeric silsesquioxane, titanium isopropoxide or any combination thereof; and
wherein the barrier layer has a water vapor transmission rate through the barrier layer of less than about 1x10⁻² g/m²/day, as measured at 25°C and with a gas having 50 percent relative humidity.

## Claims

1. A composite article (10) comprising:
a substrate (14) having a surface; and
a barrier layer (16) disposed on a surface of the substrate (14),
wherein the barrier layer (16) comprises a barrier coating and a repair coating disposed on the barrier coating, wherein the repair coating comprises a metal based compound.

2. The composite article of claim 1, wherein the substrate (14) comprises an organic polymeric resin, a glass, a metal, a ceramic, or any combination thereof.

3. The composite article of claim 1 or claim 2, wherein the barrier coating is selected from the group consisting of organic materials, inorganic materials, ceramic materials, metals, and any combination thereof.

4. The composite article of any preceding claim, wherein the metal based compound is selected from the group consisting of a metal oxide, a metal alkoxide, silica, titania, ceria, alumina and combinations thereof.

5. The composite article of claim 4, wherein the metal oxide comprises metal oxide nanoparticles having an average size in the range from about 0.5 nm to about 100 nm.

6. The composite article of claim 4, wherein the metal based compound comprises a condensation product of a metal alkoxide, wherein the metal alkoxide comprises trimethoxy methylsilane, tetraethoxy orthosilane, trisilanol isooctyl polyhedral oligomeric silsesquioxane, trisilanol phenyl polyhedral oligomeric silsesquioxane, titanium isopropoxide, aluminum isopropoxide or any combination thereof.

7. The composite article of any preceding claim, wherein the barrier layer (16) has a water vapor transmission rate through the barrier layer of less than about 1x10⁻² g/m²/day, as measured at 25°C and with a gas having 50 percent relative humidity.

8. An electroactive device comprising the composite article (10) of any preceding claim, wherein the electroactive device comprises a flexible display device, a liquid crystalline display (LCD), a thin film transistor LCD, an electroluminescent device, a light emitting diode, a light emitting device, an organic light emitting device, a photovoltaic device, an organic photovoltaic device, a photoconductor, a photodetector, an optoelectronic device, an integrated circuit, a chemical sensor, a biochemical sensor, a component of a medical diagnostic system, an electrochromic device, or any combination thereof.

9. The electroactive device of claim 8, which is encapsulated by the barrier layer (16).

10. A packaging material comprising the composite article (10) of any one of claims 1-7.
